# EUROPEAN PATENT APPLICATION

(11) **EP 3 582 260 A2**
(43) Date of publication of application: **18.12.2019**
(21) Application number: 19172944.1
(22) Date of filing: 07.05.2019
(51) Int. Cl.: H01L 23/498, H01L 23/50, H01L 25/065

(54) **ELECTRONIC PACKAGE FOR HIGH-DATA RATE COMMUNICATION APPLICATIONS**

(30) Priority: 18.05.2018 US 201862673194 P; 29.04.2019 US 201916398228
(71) Applicant: MediaTek Inc., Hsin-Chu 300 (TW)
(72) Inventor: LIN, Min-Chen, 30078 Hsin-Chu (TW); LEE, Yi-Hui, 30078 Hsin-Chu (TW); CHOU, Che-Ya, 30078 Hsin-Chu (TW); CHEN, Nan-Cheng, 30078 Hsin-Chu (TW)
(74) Representative: Hoefer & Partner Patentanwälte mbB

(57) **Abstract**

An electronic package (1) configured to operate at Gigabit-per-second (Gbps) data rates is disclosed. The electronic package (1) includes a package substrate (20) of a rectangular shape. A chip package (10) having a first high-speed interface circuit die (11) is mounted on a top surface (201) of the package substrate (20) . The chip package (10) is rotated relative to the package substrate (20) above a vertical axis (Z) that is orthogonal to the top surface (201) through about 45 degrees. The first high-speed interface circuit die (11) includes a first Serializer/Deserializer, SerDes, circuit block.

## Description

### Cross Reference to Related Applications

This application claims benefits from U.S. provisional application No. 62/673,194 filed May 18, 2018, which is included herein in its entirety by reference.

### Background

The present disclosure relates generally to the field of semiconductor packaging for high-data rate communication applications. More particularly, the present disclosure relates to an electronic package comprising a chip package having a high-speed signal processing circuit such as a serializer/deserializer (SerDes) circuit that is used to transmit and receive from a serial communication link.

Typically, a data communication network includes multiple communication devices and a connection infrastructure or medium for interconnecting or networking the communication devices. The communication devices may include embedded controllers. The communication devices may connect with high-speed analog serial data interfaces or ports configured to operate at Gigabit-per-second (Gbps) data rates (e.g., 56Gbps or 112 Gbps). The serial data interfaces are configured in accordance with known data transmission standards. The connection infrastructure is capable of interfacing with such high-speed analog serial data interfaces.

The use of high-speed serial communication links in electronic systems has continued to grow. As known in the art, high-speed data links transmit data from one location to another over transmission lines. These data links can include Serializer/Deserializer data links (i.e. SerDes) that receive data in a parallel format and convert the data to a serial format for high speed transmission. SerDes data links can be part of a backplane in a communications system.

However, the prior art chip packages for high-data communication applications, which contain SerDes circuits, usually suffer from so-called SerDes loss arose from signal skew or signal delay, which in turn deteriorates the electrical performance of the chip package.

### Summary

It is one object of the present disclosure to provide an improved semiconductor electronic package for high-data rate communication applications, which is capable of reducing signal skew or signal delay and thus improving electrical performance of the semiconductor electronic package.

According to the invention, an electronic package, preferably configured to operate at Gigabit-per-second (Gbps) data rates, is disclosed and defined in the independent claims. The dependent claims define preferred embodiments thereof. The electronic package includes a package substrate of a rectangular shape. A chip package having a first high-speed interface circuit die is mounted on a top surface of the package substrate. The chip package is rotated relative to the package substrate above a vertical axis that is orthogonal to the top surface through about 45 degrees, and/or the first high-speed interface circuit die comprises a first edge directly facing a vertex of the package substrate, wherein a first row of input/output (I/O) pads is disposed along the first edge. According to the invention, by providing the rotated chip package configuration, the corresponding traces and ball arrangement on the package substrate are concentrated within one of the four quadrants Q₁∼Q₄, resulting in a 14.3% reduction of the maximum signal length (e.g., from about 35mm to about30mm for 60x60mm∼90x90mm package substrate), and a significant reduction of trace length difference (max. length minus min. length) from 20mm to 13mm. Therefore, the skew is mitigated and the signal delay as well as the electrical performance of SerDes circuit of the electronic package can be significantly improved (e.g., with improvement by 18% or about -0.5dB) . Preferably, the first high-speed interface circuit die includes a first Serializer/Deserializer (SerDes) circuit block.

Preferably, the top surface of the package substrate is partitioned into four quadrants by two orthogonal axes in a two-dimensional plane. Prefably, the first high-speed interface circuit die comprises a second edge that is perpendicular to the first edge, wherein a second row of I/O pads is disposed along the second edge.

Preferably, a first group of solder balls is arranged along two sides joined at said vertex of the package substrate, and wherein said first row of I/O pads is electrically connected to the first group of solder balls through a plurality first traces, respectively, within one of the four quadrants on the top surface of the package substrate.

Preferably, a second group of solder balls is arranged along one of said two sides joined at said vertex of the package substrate, and wherein said second row of I/O pads is electrically connected to the second group of solder balls through a plurality second traces, respectively, within said one of the four quadrants on the top surface of the package substrate.

Preferably, the electronic package further comprises a second high-speed interface circuit die in proximity to the first high-speed interface circuit die. Preferably, the second high-speed interface circuit die comprises a second Serializer/Deserializer (SerDes) circuit block. Preferably, the first high-speed interface circuit die is electrically connected to the second high-speed interface circuit die through a redistribution layer (RDL) structure.

These and other objectives of the present invention will no doubt become obvious to those of ordinary skill in the art after reading the following detailed description of the preferred embodiment that is illustrated in the various figures and drawings.

### Brief Description of the Drawings

The accompanying drawings are included to provide a further understanding of the invention, and are incorporated in and constitute a part of this specification. The drawings illustrate embodiments of the invention and, together with the description, serve to explain the principles of the invention. In the drawings:
FIG. 1 is a perspective top view of a semiconductor electronic package according to one embodiment of the invention;
FIG. 2 is a schematic, cross-sectional diagram taken alone line I-I' in FIG. 1; and
FIG. 3 is a perspective view of the semiconductor electronic package according to one embodiment of the invention.

### Detailed Description

In the following detailed description of embodiments of the invention, reference is made to the accompanying drawings, which form a part hereof, and in which is shown by way of illustration specific preferred embodiments in which the disclosure may be practiced.

These embodiments are described in sufficient detail to enable those skilled in the art to practice them, and it is to be understood that other embodiments may be utilized and that mechanical, structural, and procedural changes may be made without departing from the spirit and scope of the present disclosure. The following detailed description is, therefore, not to be taken in a limiting sense, and the scope of embodiments of the present invention is defined only by the appended claims.

It will be understood that, although the terms first, second, third, primary, secondary, etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first or primary element, component, region, layer or section discussed below could be termed a second or secondary element, component, region, layer or section without departing from the teachings of the present inventive concept.

Spatially relative terms, such as "beneath", "below", "lower", "under", "above," "upper," "over" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" or "under" other elements or features would then be oriented "above" or "over" the other elements or features. Thus, the exemplary terms "below" and "under" can encompass both an orientation of above and below. The device may be otherwise oriented (rotated 90 degrees or at other orientations) and the spatially relative descriptors used herein interpreted accordingly. In addition, it will also be understood that when a layer is referred to as being "between" two layers, it can be the only layer between the two layers, or one or more intervening layers may also be present.

The terminology used herein is for the purpose of describing particular embodiments only and is not intended to be limiting of the inventive concept. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items, and may be abbreviated as "/".

It will be understood that when an element or layer is referred to as being "on", "connected to", "coupled to", or "adjacent to" another element or layer, it can be directly on, connected, coupled, or adjacent to the other element or layer, or intervening elements or layers may be present. In contrast, when an element is referred to as being "directly on," "directly connected to", "directly coupled to", or "immediately adjacent to" another element or layer, there are no intervening elements or layers present.

A Serializer/Deserializer (SerDes) is a pair of functional blocks commonly used in high-speed communications to compensate for limited input/output. These blocks convert data between serial data and parallel interfaces in each direction. The term "SerDes" generically refers to interfaces used in various technologies and applications. The primary use of a SerDes is to provide data transmission over a single line or a differential pair in order to minimize the number of I/O pins and interconnects. SerDes data transmission implementations can be used in a wide range of communication systems and devices, such as mobile devices, desktop computers and servers, computer networks, and telecommunication networks.

The disclosed electronic package, which is configured to operate at Gigabit-per-second (Gbps) data rates, is capable of reducing signal skew and thus improving electrical performance of the chip package, which is suited for high-data rate communication applications including, but not limited to, hyper scale data centers, ultra-high performance networking switches, routers or compute applications as well as 4G and 5G service provider (backhaul) infrastructure, AI/Deep-learning applications, and novel computing applications.

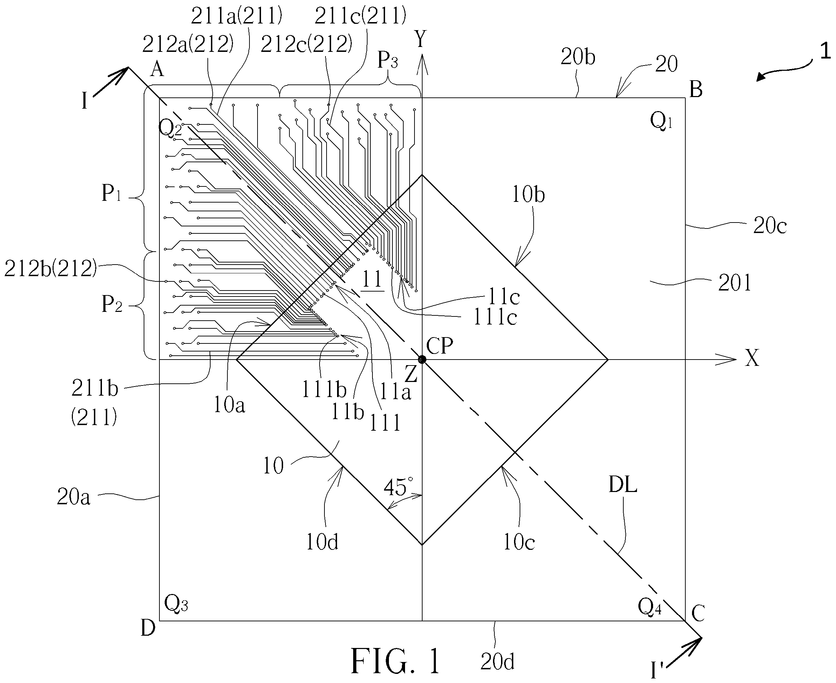

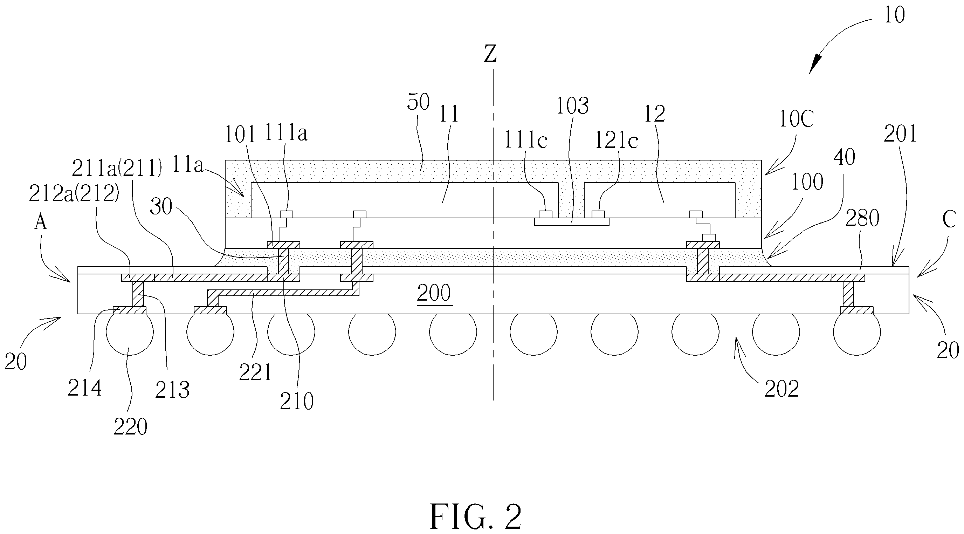

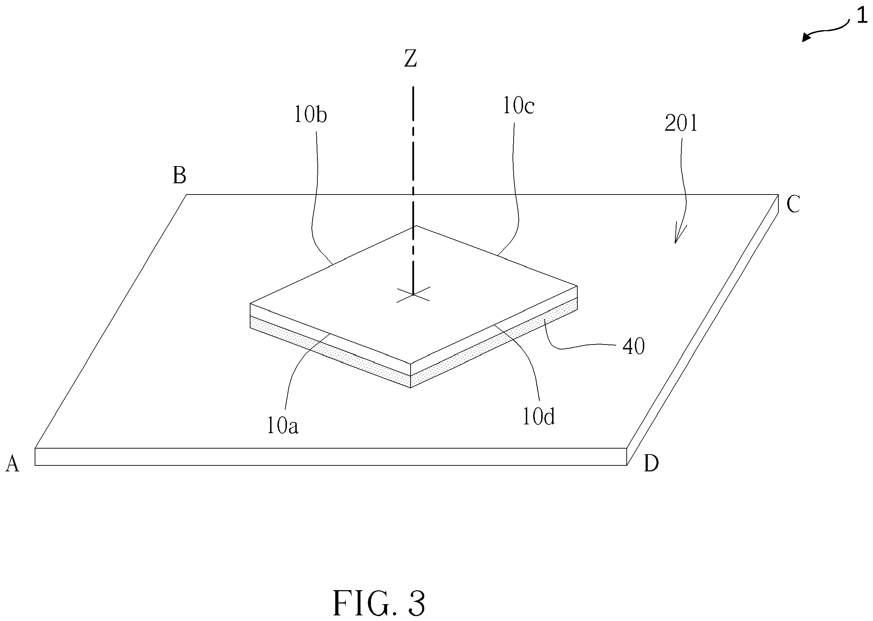

Please refer to FIG. 1 to FIG. 3. FIG. 1 is a perspective top view of an electronic package according to one embodiment of the invention. FIG. 2 is a schematic, cross-sectional diagram taken alone line I-I' in FIG. 1. FIG. 3 is a perspective view of the electronic package according to one embodiment of the invention.

As shown in FIG. 1 to FIG. 3, in accordance with one embodiment, an electronic package 1 comprises a chip package 10 that is mounted on a top surface 201 of a package substrate 20 in a flip-chip manner. The chip package 10 and the package substrate 20 may both have a rectangular shape when viewed from the above. For example, the chip package 10 and the package substrate 20 may both have a square shape having four sides of equal length. The chip package 10 has four sides 10a∼10d. The package substrate 20 has four vertices A∼D and four sides 20a∼20d between the four vertices A∼D, respectively.

As shown in FIG. 1, the top surface 201 of the package substrate 20 may be partitioned into four 90-degree quadrants Q₁∼Q₄ by two orthogonal axes (reference X and Y axes) in a two-dimensional plane (parallel to the top surface 201). The quadrants Q₁ and Q₃ are diagonally opposite each other. The quadrants Q₂ and Q₄ are diagonally opposite each other Through FIG. 1 to FIG. 3, a reference Z axis that is orthogonal to the top surface 201 or X-Y plane is shown.

Preferably, the package substrate 20 may be an organic substrate comprising laminated organic material or a core 200, such as epoxy or the like. As shown in FIG. 2, a plurality of solder balls 230 may be disposed on a bottom surface 202 of the package substrate 20. The chip package 10 is mounted on the top surface 201 of a package substrate 20 through a plurality of solder joints or bumps 30. An underfill 40 may be dispensed to fill a gap (or standoff) between the chip package 10 and the package substrate 20. The package substrate 20 may comprise multiple layers of traces, for example, traces 211 and 221.

In FIG. 2, the trace 211 is intended to be disposed in the topmost layer of the multiple layers of traces of the package substrate 20. Typically, the traces 211 may be covered with a protection layer 280 such as a solder mask or the like, but is not limited thereto. The bump 30 is joined to and aligned with a corresponding bump pad 210 at one distal end of the trace 211. The trace 211 extends toward the corner at the vertex A or toward the two adjacent sides 20a and 20b around the corner.

The traces 211 for electrically connecting the corresponding bump pads 210 are generally disposed within the exemplary revealed quadrant Q₂. The trace 211 is electrically coupled to a connection pad 212. A plated through hole (PTH) 213 may be provided to electrically connect the connection pad 212 to a solder ball pad 214 at the bottom surface 202 of the package substrate 20. A solder ball 230 is planted on the solder ball pad 214 for further connection with a system board or a printed circuit board (PCB).

For the sake of simplicity, only the traces and ball arrangement within the quadrant Q₂ is revealed in perspective view as shown in FIG. 1. The solder balls 230 are not expressly shown in FIG. 1. However, it is understood that since the connection pads 212 is aligned with the solder ball pads 214 and therefore the solder balls 230, the position of each connection pad 212 in FIG. 1 generally represents the position of each solder ball 230. It is understood that the configuration as indicated in quadrant Q₂ may be employed in the other quadrants Q₁, Q₃ and Q₄ in other embodiments.

As shown in FIG. 1 and FIG. 3, the chip package 10 and the package substrate 20 may have the same center point CP and therefore have a concentric configuration with the chip package that is angular offset relative to the package substrate 20. Preferably, the chip package 10 is rotated relative to the package substrate 20 above the Z axis through about 45 degrees.Preferably, none of the four sides 10a∼10d of the chip package 10 is parallel with any of the four sides 20a∼20d of the package substrate 20.

It is intended to rotate the chip package 10 such that its one side 10a directly faces one corner at vertex A of the package substrate 20. The two sides 20a and 20b of the package substrate 20 are joined at the vertex A. The two sides 20a and 20b define boundaries of the 90-degree quadrant Q₂.

Preferably, the chip package 10 comprises a first high-speed interface circuit die 11, which may be operated at high-speed data transmission rate of at least 1000Mbps at frequency higher than 500MHz. As shown in FIG. 2, the first high-speed interface circuit die 11 may be encapsulated within a molding compound 50. Preferably, the first high-speed interface circuit die 11 comprises a first Serializer/Deserializer (SerDes) circuit block 110 that is located in close proximity to the side 10a that directly faces one corner at vertex A of the package substrate 20.

Preferably, as shown in FIG. 1, the first high-speed interface circuit die 11 comprises a first edge 11a directly facing the corner at the vertex A of the package substrate 20, a second edge 11b that is perpendicular to the first edge 11a and is joined to the first edge 11a, and a third edge 11c that is perpendicular to the first edge 11a and is joined to the first edge 11a. Preferably, the first edge 11a is in parallel with the side 10a of the chip package 10, the second edge 11b is in parallel with the side 10d of the chip package 10, and the third edge 11c is parallel with the side 10b of the chip package 10. The second edge 11b and the third edge 11c are in parallel with a diagonal line DL extending between the vertex A and the vertex C.

Preferably, as shown in FIG. 1, a first row of input/output (I/O) pads 111a is disposed along the first edge 11a, a second row of I/O pads 111b is disposed along the second edge 11b, and a third row of I/O pads 111c is disposed along the third edge 11c. It is understood that these I/O pads 111 are disposed at a bottom of the first high-speed interface circuit die 11.

Preferably, a redistribution layer (RDL) structure 100 may be provided between the first high-speed interface circuit die 11 and the top surface 201 of the package substrate 20 to fan-out the I/O pads 111. The RDL structure 100, which is known in the art, may be composed of dielectric layers and interconnect structures in the dielectric layers for electrically connecting the I/O pads of the high-speed interface circuit die 11 to the corresponding bump pads 101 wherein the solder joint 30 is formed. Preferably, the chip package 10 may be a fan-out wafer level package (FOWLP).

Preferably, the first SerDes circuit block 110 of the first high-speed interface circuit die 11, the edges 11a∼11c, the rows of I/O pads 111a∼111c are generally disposed within the exemplary quadrant Q₂. It is understood that the chip package 10 is flipped with its active surface mounted on the top surface 201 of the package substrate 20 in a flip-chip manner.

As shown in FIG. 1, preferably, a first group of solder balls P₁ (solder balls are not explicitly shown in FIG. 1, but aligned with the connection pads 212a) is arranged along two sides 20a and 20b joined at the vertex A of the package substrate 20. The first row of I/O pads 111a disposed at the first edge 11a of the high-speed interface circuit die 11 is electrically connected to the first group of solder balls P₁ through the traces 211a, respectively, within the quadrant Q₂ on the top surface 201 of the package substrate 20.

Preferably, a second group of solder balls P₂ (solder balls are not explicitly shown in FIG. 1, but aligned with the connection pads 212b) is arranged along the side 20a adjacent to the corner at the vertex A. The second row of I/O pads 111b is electrically connected to the second group of solder balls P₂ through traces 211b, respectively, within the quadrant Q₂ on the top surface 201 of the package substrate 20.

Preferably, a third group of solder balls P₃ (solder balls are not explicitly shown in FIG. 1, but aligned with the connection pads 212c) is arranged along the side 20b adjacent to the corner at the vertex A. The second row of I/O pads 111c is electrically connected to the third group of solder balls P₃ through traces 211c, respectively, within the quadrant Q₂ on the top surface 201 of the package substrate 20.

Preferably, as shown in FIG. 2, the chip package 10 may further comprises a second high-speed interface circuit die 12 in proximity to the first high-speed interface circuit die 11. The second high-speed interface circuit die 12 may comprise a SerDes circuit block 120 and may have similar trace and ball arrangement in the quadrant Q₄ of the top surface 201 of the package substrate 20. The first high-speed interface circuit die 11 may be electrically connected to the second high-speed interface circuit die 12 through the RDL structure 100. For example, the I/O pad 111c of the first high-speed interface circuit die 11 is electrically connected to the I/O pad 121c of the second high-speed interface circuit die 12 through the interconnect line 103 in the RDL structure 100.

It is advantageous to use the present disclosure because by providing the rotated chip package configuration, the corresponding traces and ball arrangement on the package substrate are concentrated within one of the four quadrants Q₁∼Q₄, resulting in a 14.3% reduction of the maximum signal length (e.g., from about 35mm to about30mm for 60x60mm∼90x90mm package substrate), and a significant reduction of trace length difference (max. length minus min. length) from 20mm to 13mm. Therefore, the skew is mitigated and the signal delay as well as the electrical performance of SerDes circuit of the electronic package can be significantly improved (e.g., with improvement by 18% or about -0.5dB).

Those skilled in the art will readily observe that numerous modifications and alterations of the device and method may be made while retaining the teachings of the invention. Accordingly, the above disclosure should be construed as limited only by the metes and bounds of the appended claims.

## Claims

1. An electronic package (1), comprising:
a package substrate (20) of a rectangular shape; and
a chip package (10) comprising a first high-speed interface circuit die (11), mounted on a top surface (201) of the package substrate (20), wherein the chip package (10) is rotated relative to the package substrate (20) above a vertical axis (Z) that is orthogonal to the top surface (201) through about 45 degrees.

2. The electronic package according to claim 1, wherein the top surface (201) of the package substrate (20) is partitioned into four quadrants (Q₁ ∼ Q₄) by two orthogonal axes (X, Y) in a two-dimensional plane.

3. The electronic package according to claim 1 or 2, wherein the first high-speed interface circuit die (11) comprises a first edge (11a) directly facing a vertex (A) of the package substrate (20), wherein a first row of input/output, in the following also referred to as I/O, pads (111a) is disposed along the first edge (11a).

4. An electronic package (1), comprising:
a package substrate (20) of a rectangular shape; and
a chip package (10) comprising a first high-speed interface circuit die, mounted on a top surface (201) of the package substrate (20), wherein the first high-speed interface circuit die comprises a first edge (11a) directly facing a vertex (A) of the package substrate (20), wherein a first row of input/output, in the following also referred to as I/O, pads (111a) is disposed along the first edge (11a).

5. The electronic package according to claim 4, wherein the top surface (201) of the package substrate (20) is partitioned into four quadrants (Q₁ ∼ Q₄) by two orthogonal axes (X, Y) in a two-dimensional plane.

6. The electronic package according to claim 4 or 5, wherein the chip package (10) is rotated relative to the package substrate (20) above a vertical axis (Z) that is orthogonal to the top surface (201) through about 45 degrees.

7. The electronic package according to claim 3 or 6, wherein the first high-speed interface circuit die (11) comprises a second edge (11b) that is perpendicular to the first edge (11a), wherein a second row of I/O pads (111b) is disposed along the second edge (11b).

8. The electronic package according to claim 7, wherein a first group of solder balls (P₁) is arranged along two sides (20a, 20b) joined at said vertex (A) of the package substrate (20), and wherein said first row of I/O pads (111a) is electrically connected to the first group of solder balls (P₁) through a plurality first traces (211a), respectively, within one of the four quadrants (Q₂) on the top surface (201) of the package substrate (20).

9. The electronic package according to claim 8, wherein a second group of solder balls (P₂) is arranged along one of said two sides (20a) joined at said vertex (A) of the package substrate (20), and wherein said second row of I/O pads (111b) is electrically connected to the second group of solder balls (P₂) through a plurality second traces (211b), respectively, within said one of the four quadrants (Q₂) on the top surface (201) of the package substrate (20).

10. The electronic package according to any one of the preceeding claims, wherein the first high-speed interface circuit die (11) comprises a first Serializer/Deserializer, in the following also referred to as SerDes, circuit block.

11. The electronic package according to any one of the preceeding claims, further comprising:
a second high-speed interface circuit die (12) in proximity to the first high-speed interface circuit die (11).

12. The electronic package according to claim 11, wherein the second high-speed interface circuit die (12) comprises a second SerDes circuit block.

13. The electronic package according to claim 11 or 12, wherein the first high-speed interface circuit die (11) is electrically connected to the second high-speed interface circuit die (12) through a redistribution layer, in the following also referred to as RDL, structure (100).
